# EUROPEAN PATENT SPECIFICATION

(11) **EP 3 876 401 B1**
(45) Date of publication and mention of the grant of the patent: **22.02.2023**
(21) Application number: 19911192.3
(22) Date of filing: 23.12.2019
(51) Int. Cl.: H02K 11/02, H05K 1/02

(54) **ELECTRONIC CONTROL ASSEMBLY AND ELECTRIC APPLIANCE**
ELEKTRONISCHE STEUERUNGSANORDNUNG UND ELEKTRISCHES GERÄT
ENSEMBLE DE COMMANDE ÉLECTRONIQUE ET APPAREIL ÉLECTRIQUE

(30) Priority: 25.01.2019 CN 201910077807
(43) Date of publication of application: 08.09.2021
(73) Proprietor: Guangdong Midea White Home Appliance Technology Innovation Center Co., Ltd., Beijiao, Shunde Foshan, Guangdong 528311 (CN); Midea Group Co., Ltd., Foshan, Guangdong 528311 (CN)
(72) Inventor: YANG, Zhilong, Foshan, Guangdong 528311 (CN); HOU, Junfeng, Foshan, Guangdong 528311 (CN); HU, Jian, Foshan, Guangdong 528311 (CN)
(74) Representative: Lam, Alvin
(86) International application number: PCT/CN2019/127430
(87) International publication number: WO 2020/151437

(56) References cited:
- EP-A1- 3 852 250
- CN-A- 101 582 607
- CN-A- 102 751 863
- CN-A- 107 742 956
- CN-U- 202 840 844
- CN-U- 206 743 047
- CN-Y- 2 254 249
- JP-A- 2011 250 545
- US-A1- 2018 007 785

## Description

This application claims priority to Chinese Patent Application No. 201910077807.8, filed on January 25, 2019 and entitled "electrical control assembly and electrical device".

### TECHNICAL FIELD

The described embodiments relate to the field of electrical control technology, and in particular to an electrical control assembly and electrical device.

### BACKGROUND

Electromagnetic compatibility refers to an ability of a device or a system to operate in an electromagnetic environment in accordance with requirements and without producing intolerable electromagnetic interference to any device in the environment. Therefore, electromagnetic compatibility has two requirements: on the one hand, the electromagnetic interference generated by the device during a normal operation process to the environment where it is located cannot exceed a certain limitation; on the other hand, the device has a certain degree of immunity to the electromagnetic interference present in the environment where it is located, i.e. electromagnetic sensitivity.

At present, for an electrical device with a motor, the motor is prone to produce noise with an extremely wide spectrum while running, which is easily conducted to other circuit modules of the electrical device via a ground wire, increasing electromagnetic compatibility interference of the electrical device. US 2018/007785 A1 discloses a power circuit device including a rectifier circuit, an inverter, a first electrical wire that connects a positive polarity side of the rectifier circuit and the inverter, a second electrical wire that connects a negative polarity side of the rectifier circuit and the inverter, a ground terminal that can connect a load connected to an output terminal of the inverter, and a conductive plate that connects at least one of the first electrical wire and second electrical wire and the ground wire terminal. EP 3852250 A, considered to be prior art pursuant to Article 54(3) EPC, 1 discloses an
electric control assembly comprising: an electric control board provided with a first filter circuit and a power supply line for supplying power to an electric load, wherein the power supply line comprises a power source input end, a rectifier circuit, an intelligent power module and a power source output end; the power source input end, the rectifier circuit, the intelligent power module and the power source output end are connected in sequence; and a first end of the first filter circuit is connected to the power supply line; a metal plate, wherein the metal plate is disposed on one side of the electric control board in parallel, and the two are disposed at an interval; the metal plate is electrically connected to a housing of the electric load; a second end of the first filter circuit is electrically connected to the metal plate.

### SUMMARY

The present disclosure provides an electrical control assembly and electrical device for the purpose of suppressing electromagnetic compatibility electromagnetic radiation generated during the operation of a motor and improving the electromagnetic compatibility interference immunity of the electrical device.

To achieve the above purpose, the present disclosure provides an electrical control assembly in accordance with the present invention, as recited by claim 1. Preferred features are set out in the dependent claims.. The electrical control assembly includes an electrical control board, a power filter circuit and an electromagnetic compatibility filter circuit. The electrical control board is provided with a system protection ground, a power input terminal and a ground terminal configured to access a power supply, and a power output terminal and a motor ground terminal configured to access a motor, wherein the ground terminal is connected with the system protection ground. An input end of the power filter circuit is connected with the power input terminal. An output end of the power filter circuit is connected with the power output terminal. An input end of the electromagnetic compatibility filter circuit is connected with the motor ground terminal and a ground end of the power filter circuit. An output end of the electromagnetic compatibility filter circuit is connected with the system protection ground.

The ground terminal includes a plurality of plug-in ends. The motor ground terminal includes a plurality of plug-in ends. A plurality of printed circuit board wires are arranged on the electrical control board. First ends of the plurality of printed circuit board wires are connected to the plurality of plug-in ends of the ground terminal in one-to-one correspondence. The other ends of the plurality of printed circuit board wires are connected to the plurality of plug-in ends of the motor ground terminal in one-to-one correspondence. The electromagnetic compatibility filtering circuit includes a plurality of electromagnetic compatibility filter branches. Each of the plurality of electromagnetic compatibility filter branches is connected in series to a corresponding printed circuit board wire.

Optionally, the ground terminal may include two plug-in ends. The motor ground terminal may include two plug-in ends. A first printed circuit board wire and a second printed circuit board wire may be arranged on the electrical control board. The first printed circuit board wire may be connected with a first plug-in end of the motor ground terminal and a first plug-in end of the ground terminal. The second printed circuit board wire may be connected with a second plug-in end of the motor ground terminal and a second plug-in end of the ground terminal. The electromagnetic compatibility filter circuit may include two electromagnetic compatibility filter branches. One of the two electromagnetic compatibility filter branches may be connected in series to the first printed circuit board wire. The other of the two electromagnetic compatibility filter branches may be connected in series to the second printed circuit board wire.

Optionally, the electromagnetic compatibility filter circuit may include a first magnetic bead. A first end of the first magnetic bead may be the input end of the electromagnetic compatibility filter circuit. A second end of the first magnetic bead may be the output end of the electromagnetic compatibility filter circuit.

Optionally, the quantity of the first magnetic bead may be multiple. A plurality of the first magnetic beads may be connected in series to the first printed circuit board wire and the second printed circuit board wire.

Optionally, the electromagnetic compatibility filter circuit may include an inductor. A first end of the inductor may be the input end of the electromagnetic compatibility filter circuit. A second end of the inductor may be the output end of the electromagnetic compatibility filter circuit.

Optionally, the power filter circuit may include a common mode choke, a first Y-capacitor and a second Y-capacitor. Each of two input ends of the common mode choke may be connected to an input end of the power supply. Two output ends of the common mode choke may be connected to a first end of the first Y-capacitor and a first end of the second Y-capacitor respectively. A second end of the first Y-capacitor and a second end of the second Y-capacitor may be each connected to an input end of the electromagnetic compatibility filter circuit.

Optionally, the electromagnetic compatibility filter circuit may further include a second magnetic bead. A first end of the second magnetic bead may be connected to the motor ground terminal. A second end of the second magnetic bead may be connected to the first end of the first magnetic bead.

Optionally, the electromagnetic compatibility filter circuit may further include a third magnetic bead. A first end of the third magnetic bead may be interconnected with the first magnetic bead and the second end of the first Y-capacitor. A second end of the third magnetic bead may be interconnected with a second end of the second magnetic bead and the motor ground terminal.

Optionally, the electromagnetic compatibility filter circuit may further include a fourth magnetic bead.

The fourth magnetic bead may be connected in series between an output end of the common mode choke and the first Y-capacitor.

Alternatively, the fourth magnetic bead may be connected in series between an output end of the common mode choke and the second Y-capacitor.

Optionally, the electrical control assembly may further include a rectifier circuit, a power factor correction circuit and an intelligent power module connected in sequence.

The present disclosure further provides an electrical device. The electrical device may include a motor and the electrical control assembly as described above. The power output terminal of the electrical control assembly may be connected with the motor.

In the present disclosure, the electromagnetic compatibility filter circuit may be connected in series between the ground wire of the housing of the motor and the system protection ground. One end of the electromagnetic compatibility filter circuit may be electrically connected to the housing of the motor via the motor ground terminal and may be also connected to the ground end of the power filter circuit, and the other end may be connected to the system protection ground. When the noise generated during the operation of the motor with an extremely wide frequency spectrum flows to the electrical control board through the ground wire and the motor ground terminal, the electromagnetic compatibility filter circuit can provide high frequency impedance. In this case, the connection between the electromagnetic compatibility filter circuit and the power filter circuit may be equivalent to a parallel connection. Since the electromagnetic compatibility filter circuit is equivalent to a high frequency impedance circuit, the current flowing through the electromagnetic compatibility filter circuit may be much smaller than that flowing through the power filter circuit. In this way, a current loop may be formed among the housing of the motor, the ground wire of the motor, the motor ground terminal, the ground end of the power filter circuit, the output end of the power filter circuit, the power output terminal, a power end of the motor and windings of the motor. The electromagnetic compatibility interference signal can return to the generation source of the electromagnetic compatibility interference signal through the housing of the motor, the ground wire, the ground terminal of the motor, the power filter circuit and the power output terminal, thereby preventing the electromagnetic compatibility interference signal from flowing out of the motor. Moreover, the electromagnetic compatibility interference signal may also be gradually consumed in a form of heat generation during flowing through the current loop formed by the power filter circuit, the windings of the motor and the housing of the motor and other structures, thus preventing the electromagnetic compatibility interference of the motor from exceeding a standard. In the present disclosure, the electromagnetic compatibility filter circuit may be arranged between the ground wire of the motor and the system protection ground to increase the high-frequency impedance of the current loop on the path where the common mode interference generated by the motor flows back to the line impedance stabilization network of the electrical control board through the system protection ground, so that the power filter circuit, which is set in parallel with the electromagnetic compatibility filter circuit, can share a larger common mode current and the electromagnetic compatibility interference signal can be attenuated by the power filter circuit, thereby suppressing the transmission of electromagnetic compatibility interference signals and the like to the system protection ground. In this way, the electromagnetic compatibility electromagnetic radiation generated by the motor can be suppressed and the electromagnetic compatibility interference immunity of electrical device can be improved.

### BRIEF DESCRIPTION OF THE DRAWINGS

FIG. 1 is a schematic diagram of functional modules of an electrical control assembly according to an embodiment of the present disclosure;
FIG. 2 is a schematic diagram of functional modules of an electrical control assembly according to another embodiment of the present disclosure;
FIG. 3 is a schematic circuit diagram of an electrical control assembly according to a first embodiment of the present disclosure;
FIG. 4 is a schematic circuit diagram of an electrical control assembly according to a second embodiment of the present disclosure;
FIG. 5 is a schematic circuit diagram of an electrical control assembly according to a third embodiment of the present disclosure;
FIG. 6 is a structural view of an electrical control assembly according to an embodiment of the present disclosure;
FIG. 7 is a schematic circuit diagram of an electrical control assembly according to a fourth embodiment of the present disclosure;
FIG. 8 is a schematic circuit diagram of an electrical control assembly according to a fifth embodiment of the present disclosure;
FIG. 9 is a schematic circuit diagram of an electrical control assembly according to a sixth embodiment of the present disclosure;
FIG. 10 is a schematic circuit diagram of an electrical control assembly according to a seventh embodiment of the present disclosure.

Reference numerals in the drawings are described as follows.

**[Form 1]**

| reference numeral | name | reference numeral | name |
|---|---|---|---|
| 100 | electrical control board | CN11 | power input terminal |
| GND | system protection ground | CN12 | ground terminal |
| 10 | power filter circuit | CN21 | power output terminal |
| 20 | electromagnetic compatibility filter circuit | CN22 | motor ground terminal |
| 30 | rectifier circuit | FB1 | first magnetic bead |
| 40 | PFC circuit | FB2 | second magnetic bead |
| 50 | IPM | FB3 | third magnetic bead |
| L1 | common mode choke | FB4 | fourth magnetic bead |
| L2 | inductor | C1 | first Y capacitor |
| M1 | motor | C2 | second Y capacitor |

### DETAILED DESCRIPTION

The present disclosure provides an electrical control assembly for an electrical device. The electrical device may be an air conditioner, a washing machine or other household electrical device. The electric control assembly may be particularly suitable for air conditioners.

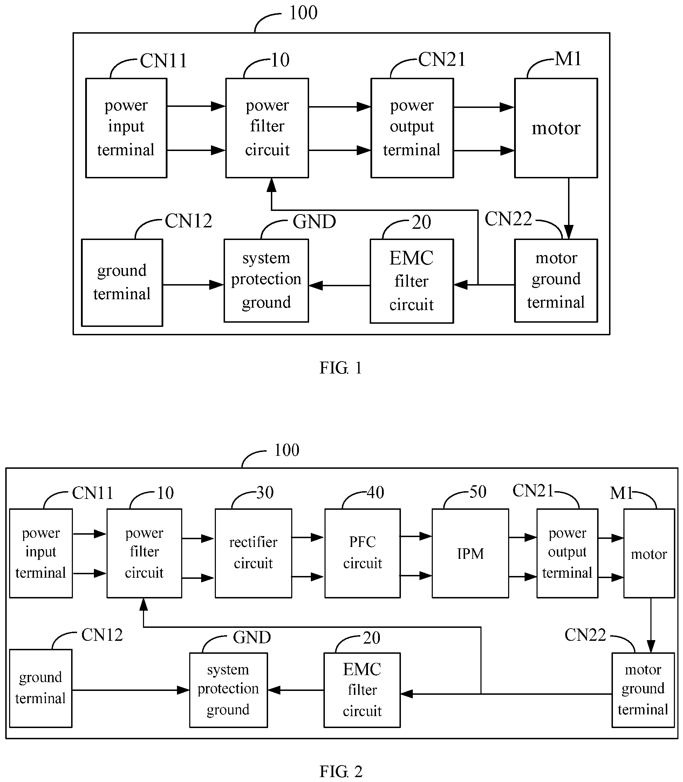

Referring to FIGS. 1 and 2, in an embodiment of the present disclosure, the electrical control assembly may include an electrical control board 100, a power filter circuit 10 and an electromagnetic compatibility (EMC) filter circuit 20.

The electrical control board 100 may be provided with a system protection ground GND, a power input terminal CN11 and a ground terminal CN12 configured to access a power supply, and a power output terminal CN21 and a motor ground terminal CN22 configured to access a motor M1. The ground terminal CN12 may be connected to the system protection ground GND.

An input end of the power filter circuit 10 may be connected with the power input terminal CN11. An output end of the power filter circuit 10 may be connected with the power output terminal CN21.

An input end of the electromagnetic compatibility filter circuit 20 may be connected with the motor ground terminal CN22 and a ground end of the power filter circuit 10, respectively. An output end of the electromagnetic compatibility filter circuit 20 may be connected with the system protection ground GND.

In this embodiment, the electrical control board 100 may be a single-sided board or a double-sided board, which can be determined according to installation space and installation location of the electrical device in the actual application. In some embodiments, the electrical control assembly may further include a rectifier circuit 30, a PFC (power factor correction) circuit 40 and an IPM (intelligent power module) 50. The power input terminal CN11 may include a zero wire AC-N and a fire wire AC-L. The power output terminal CN21 may include a UVW three-phase output port.

Rectifier circuit 30 may be a rectifier bridge stack, or a rectifier circuit 30 consisting of four separate diodes. Rectifier circuit 30 may convert an incoming alternating current (AC) power to direct current (DC) power and then output the DC power to the PFC circuit 40 for a power factor adjustment. The PFC circuit 40 may be a passive PFC circuit 40 to form a step-up PFC circuit 40, or a step-down PFC circuit 40, or a step-up and step-down PFC circuit 40. The PFC circuit 40 may perform a power factor adjustment on the incoming DC, for example by increasing a voltage of the DC power to be stabilized at 380V so that an input current follows an input voltage, maintaining the power factor of the DC power above 0.9. After being adjusted, the DC power can be output to a rear stage circuit, such as the IPM 50. The DC power after being adjusted can also pass through a switching power circuit (not shown) to generate driving voltages with various values, e.g. 5V, 15V, etc. to power other components on the circuit board such as a main controller. The IPM 50 can be arranged on the electrical control board 100 and integrate a driving circuit and a plurality of power switching tubes. The plurality of power switching tubes can form a driving inverter circuit. For example, six power switching tubes can form a three-phase inverter bridge circuit, or four power switching tubes can form a two-phase inverter bridge circuit. Each power switching tube may be a MOS tube or an IGBT. The IPM 50 can be configured to drive the motor M1 of a compressor. Of course, in other embodiments, IPM 50 can also be configured to drive frequency converters and various inverter power supplies of other motors M1, and can be applied in areas such as frequency conversion and speed regulation, metallurgical machinery, electric traction, servo drive, and inverter appliance such as air conditioner and so on.

In the present embodiment, the output end of the power filter circuit 10 may be connected to an input end of the rectifier circuit 30. The input end of the power filter circuit 10 may be connected to the power input terminal CN11. After the power input terminal CN11 accesses an AC power supply, common mode current in this input power supply can be suppressed by the power filter circuit 10, thereby suppressing grid noise and high harmonics of the AC power supply, and the noise and high frequency harmonics generated by a switching power supply, meanwhile preventing the electromagnetic interference generated in a power circuit from radiating to other circuit modules.

It should be noted that the motor M1 may be a motor M1 of a compressor, a motor M1 of a fan, or other motor M1 in the electrical device. A housing of the motor M1 may generally be a metal housing. A ground wire of the motor M1 can generally be connected to the metal housing and further connected to a ground wire on the electrical control board 100 through a wire, so that the housing of the motor M1 may also act as a ground protection wire, thus connecting all circuit modules on the electrical control board 100 and the AC power supply together to form an equal potential, and forming a metal network loop, i.e. the system protection ground, to achieve a leakage protection and also to prevent static electricity from damaging the electrical device. The motor of the electrical device can be either a brushed motor or a brushless motor. When in operation, the motor may be prone to generate electromagnetic interference. For example, when a brushed motor M1 is used, due to an increase of DC resistance between the brush and commutator of the brushed motor, spark discharge may be prone to form, and the brushed motor M1 may be prone to generate noise with an extremely wide spectrum (continuously distributed from the mid-wave to the VHF band), while the brushed motor M1 is rotating. The brushless motor may also generate a high-frequency noise during an operation. The noise can be easily radiated to the housing of the motor M1 and conducted through the housing of the motor M1 and the ground wire to the electrical control board 100 and then through the electrical control board 100 to other circuit modules, which may even increase electromagnetic interference, i.e., electromagnetic compatibility interference signals among various electrical devices such as air conditioners and washing machines.

To solve the above problem, in this embodiment, the electromagnetic compatibility filter circuit 20 may be connected in series between the ground wire of the housing of the motor M1 and the system protection ground GND. One end of the electromagnetic compatibility filter circuit 20 may be electrically connected to the housing of the motor M1 via the motor ground terminal CN22 and may be also connected to the ground end of the power filter circuit 10, and the other end may be connected to the system protection ground GND. When the noise generated during the operation of the motor M1 with an extremely wide frequency spectrum flows to the electrical control board 100 through the ground wire and the motor ground terminal CN22, the electromagnetic compatibility filter circuit 20 can provide high frequency impedance. In this case, the connection between the electromagnetic compatibility filter circuit 20 and the power filter circuit 10 may be equivalent to a parallel connection. Since the electromagnetic compatibility filter circuit 20 is equivalent to a high frequency impedance circuit, the current flowing through the electromagnetic compatibility filter circuit 20 may be much smaller than that flowing through the power filter circuit 10. In this way, a current loop may be formed among the housing of the motor M1, the ground wire of the motor M1, the motor ground terminal CN22, the ground end of the power filter circuit 10, the output end of the power filter circuit 10, the power output terminal CN21, a power end of the motor M1 and windings of the motor M1. The electromagnetic compatibility interference signal can return to the generation source of the electromagnetic compatibility interference signal through the housing of the motor M1, the ground wire, the ground terminal of the motor M1, the power filter circuit 10 and the power output terminal CN21, thereby preventing the electromagnetic compatibility interference signal from flowing out of the motor M1. Moreover, the electromagnetic compatibility interference signal may also be gradually consumed in a form of heat generation while flowing through the current loop formed by the power filter circuit 10, the windings of the motor M1 and the housing of the motor M1 and other structures, thus preventing the electromagnetic compatibility interference of the motor M1 to the electrical control board 100 and other modules in the electrical device from exceeding a standard. In the present disclosure, the electromagnetic compatibility filter circuit 20 may be arranged between the ground wire of the motor M1 and the system protection ground GND to increase the high-frequency impedance of the current loop on the path where the common mode interference generated by the motor M1 flows back to the line impedance stabilization network of the electrical control board 100 through the system protection ground GND, so that the power filter circuit 10, which is set in parallel with the electromagnetic compatibility filter circuit 20, can share a larger common mode current and the electromagnetic compatibility interference signal can be attenuated by the power filter circuit 10, thereby suppressing the transmission of electromagnetic compatibility interference signals and the like to the system protection ground GND. In this way, the electromagnetic compatibility electromagnetic radiation generated by the motor M1 can be suppressed and the electromagnetic compatibility interference immunity of electrical device can be improved.

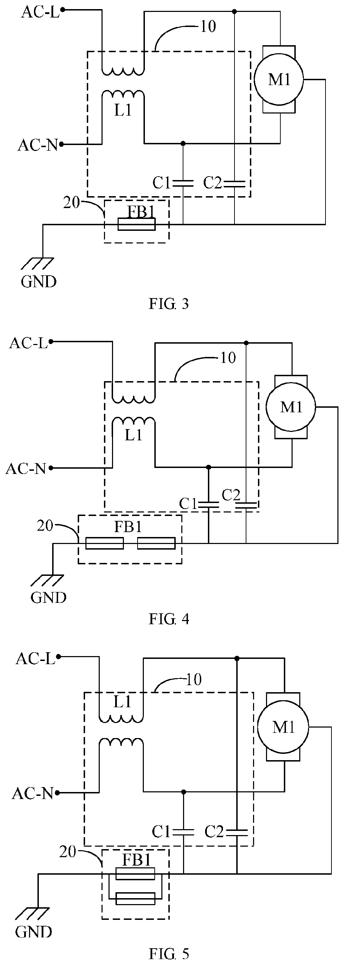

As shown in FIGS. 4 to 6, both the ground terminal CN12 and the motor ground terminal CN22 may include a plurality of plug-in ends. A plurality of printed circuit board wires may also be provided on the electrical control board 100. First ends of the plurality of printed circuit board wires may be connected to the plurality of plug-in ends of the ground terminal CN12 in one-to-one correspondence. The other ends of the plurality of printed circuit board wires may be connected to the plurality of plug-in ends of the motor ground terminal CN22 in one-to-one correspondence.

The electromagnetic compatibility filtering circuit 20 may include a plurality of electromagnetic compatibility filter branches. Each of the plurality of electromagnetic compatibility filter branches may be connected in series to a corresponding printed circuit board wire.

It should be noted that, currently, the ground wire of the motor M1 is usually directly connected to the system protection ground GND of the electrical control board 100 through the motor ground terminal CN22, without setting up a printed circuit board wire. However, in the present embodiment, in order to suppress the electromagnetic compatibility electromagnetic radiation generated by the motor M1 and improve the electromagnetic compatibility anti-interference performance of the electrical device, the electromagnetic compatibility filter circuit 20 can be arranged between the ground wire of the motor M1 and the system protection ground GND.

When the electromagnetic compatibility filter circuit 20 is provided between the ground wire of the motor M1 and the system protection ground GND, it is necessary to provide printed circuit board wires for the ground wire of the motor M1 on the electrical control board 100. However, according to the national standard, normally printed circuit board wires cannot be arranged between the ground wire of the motor M1 and the system protection ground GND, which cannot be used to provide ground continuity in order to avoid the problem of unmet ground continuity. For this reason, in the present disclosure, multiple printed circuit board wires can be provided to keep a low resistance of the ground wire, and both the ground terminal CN12 and the motor ground terminal CN22 have multiple plug-in ends, so that the electromagnetic compatibility filter circuit 20 can be configured to include multiple electromagnetic compatibility filter branches. In addition, the multiple electromagnetic compatibility filter branches may be connected in series with the printed circuit board wires, which can increase the high frequency impedance of the printed circuit board wires and thus increase the high frequency impedance of the loop, so that the power filter circuit 10, which is arranged in parallel with the electromagnetic compatibility filter circuit 20, can share a larger common mode current. In this way, the restrictive requirements of the ground continuity of the printed circuit board can be satisfied, meanwhile the electromagnetic compatibility electromagnetic radiation generated by the motor M1 can be suppressed, thus improving the electromagnetic compatibility anti-interference performance of electrical device.

Further, both the ground terminal CN12 and the motor ground terminal CN22 may include two plug-in ends. A first printed circuit board wire and a second printed circuit board wire may also be provided on the electrical control board 100. The first printed circuit board wire may be connected with a first plug-in end of the motor ground terminal CN22 and a first plug-in end of the ground terminal CN12. The second printed circuit board wire may be connected with a second plug-in end of the motor ground terminal CN22 and a second plug-in end of the ground terminal CN12.

The electromagnetic compatibility filter circuit 20 may include two electromagnetic compatibility filter branches. One of the two electromagnetic compatibility filter branches may be connected in series to the first printed circuit board wire. The other of the two electromagnetic compatibility filter branches may be connected in series to the second printed circuit board wire.

It can be understood that in practical application, the ground terminal CN12 and the motor ground terminal CN22 on the electric control board 100 may usually be provided as two, so that the AC power supply and the ground wire of the motor M1 can be connected to the electrical control board 100. In this disclosure, two printed circuit board wires may be provided according to the number of ground terminal CN12 and motor ground terminal CN22, and the two ends of the printed circuit board wires may be connected to pads of the plug-in ends of the ground terminal CN12 and motor ground terminal CN22, respectively, and two electromagnetic compatibility filter branches can be connected in series to the printed circuit board wires. In this way, the restriction requirement to the continuity of the ground wire of the printed circuit board can be satisfied, meanwhile, process steps for manufacturing the electrical control assembly can be reduced and production cost of the electrical control assembly can be decreased.

Referring to FIG. 3, in one embodiment, the electromagnetic compatibility filter circuit 20 may include a first magnetic bead FB1. A first end of the first magnetic bead FB1 may be the input end of the electromagnetic compatibility filter circuit 20. A second end of the first magnetic bead FB1 may be the output end of the electromagnetic compatibility filter circuit 20.

In this embodiment, the first magnetic bead FB1 may be a ferrite bead. In some embodiments, the electromagnetic compatibility filter circuit 20 may also be a ferrite magnetic ring. High frequency noise as well as some spike interference output from the housing of the motor M1 can be suppressed by means of the first magnetic bead FB1. The first magnetic bead FB1 may be connected in series between the housing of the motor M1 and the system protection ground GND to provide high frequency impedance for the circuit where the housing of the motor M1 and the system protection ground GND are located, so as to ensure that the common mode current flowing through the first magnetic bead FB1 is much smaller than the common mode current flowing through the power filter circuit 10, so that most of the common mode current generated by the motor M1 can return to the interference source through the power filter circuit 10 which is arranged in parallel with the first magnetic bead FB1, and the electromagnetic compatibility interference signal can be attenuated by the power supply filter circuit 10, thereby suppressing the transmission of electromagnetic compatibility interference signal, etc. to the system protection ground GND.

It is understandable that a through-core inductor may usually be connected in series to a power wire of the motor to suppress the electromagnetic compatibility interference of the electrical control assembly, which has higher costs. Moreover, since the through-core inductor has a large size, arranging the through-core inductor on the electrical control board 100 will result in a complex configuration of the electrical control board 100. In addition, since the heat generated by the through-core inductor is serious, a radiator will be needed for heat dissipation, which brings great inconvenience to the manufacturing of electrical control assembly. However, in the embodiment of the present disclosure, two printed circuit board wires may be arranged between the two plug-in ends of the ground terminal CN12 and the two plug-in ends of the motor ground terminal CN22, and the first magnetic bead FB1 may further be connected in series to the two printed circuit board wires with independent solder joints. Because of a small size of the first magnetic bead FB1, a simple circuit configuration and a lack of need for a heat sink, the difficulty of wiring the circuit of the electrical control board 100 can be thus reduced, making the electrical control assembly easy to be implemented. In the present disclosure, instead of the through-core inductor, the first magnetic bead FB1 may be used to reduce the use of heat sinks and the production costs of the electrical control assembly can be decreased.

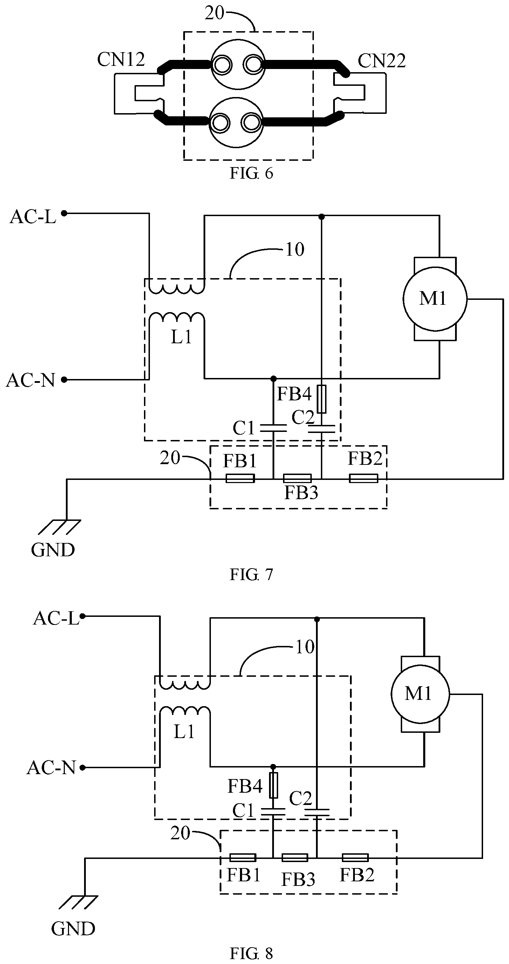

Referring to FIG. 6, in one embodiment, both the ground terminal CN12 and the motor ground terminal CN22 may include a plurality of plug-in ends.

The quantity of the first magnetic bead FB1 may be multiple. First ends of a plurality of first magnetic beads FB1 may be connected to the plurality of plug-in ends of the motor ground terminal CN22 in one-to-one correspondence. Second ends of the plurality of first magnetic beads FB1 may be connected to the plurality of plug-in ends of the ground terminal CN22 in one-to-one correspondence.

In this embodiment, the quantity of the first magnetic bead FB1 may be one or multiple, which can be determined according to the frequency of the electromagnetic interference generated by the motor M1. In practical application, the electromagnetic interference generated between a brush and a commutator of the motor M1 and by other components of the motor M1 may be detected, and the quantity of first magnetic bead FB 1 can be determined according to the frequency of the electromagnetic interference, in order to better suppress the transmission of the electromagnetic compatibility interference signal and the like to the system protection ground GND.

The quantity of first magnetic bead FB1 may be two. Correspondingly, plug-in pins of the motor ground terminal CN22 may be two and pins of the ground terminal CN12 may also be two. Among the two first magnetic beads FB1 in a parallel connection, two ends of one first magnetic bead FB1 may be respectively connected to one plug-in end of the motor ground terminal CN22 and one plug-in end of the ground terminal CN12, two ends of the other first magnetic bead FB1 may be connected to the other plug-in end of the motor ground terminal CN22 and the other plug-in end of the ground terminal CN12, respectively. In this way, while manufacturing the printed circuit board, two printed circuit board wires can be laid between the input end of the electromagnetic compatibility filter circuit 20, i.e. the motor ground terminal CN22, and the output end of the electromagnetic compatibility filter circuit 20, i.e. the ground terminal CN12, as ground connections, and the first magnetic beads FB1 can be installed on both ground wires in order to play a role in isolation and filtering.

Referring to FIG 4, in some embodiments, the quantity of first magnetic bead FB1 may be multiple. A plurality of first magnetic beads FB1 may be connected in series to the first printed circuit board wire and the second printed circuit board wire, respectively. When the quantity of the first magnetic bead FB1 is a multiple, multiple first magnetic beads FB1 may be provided in series or in parallel, depending on the frequency of electromagnetic interference generated by the motor M1, without limitation here.

As shown in FIG. 7, in one embodiment, the power filter circuit 10 may include a common mode choke L1, a first Y-capacitor C1 and a second Y-capacitor C2. Each of two input ends of the common mode choke L1 may be connected to an input end of the power supply. Two output ends of the common mode choke L1 may be connected to a first end of the first Y-capacitor C1 and a first end of the second Y-capacitor C2, respectively. A second end of the first Y-capacitor C1 and a second end of the second Y-capacitor C2 may be each connected to an input end of the electromagnetic compatibility filter circuit 20, respectively.

In the present embodiment, when there is a differential mode interference signal in the AC power supply connected to the power input terminal CN11, the magnetic fields generated by currents in two coils may cancel out due to the opposite direction of the magnetic fields as the differential mode current flows through the two coils of the common mode choke L1. When there is a common mode interference signal, since the common mode currents in the common mode choke L1 have a same direction, the two coils can generate magnetic fields in a same direction, thus increasing inductance of the two coils, i.e., increasing the inductive resistance of the two coils to the common mode current. In this way, the common mode current can be more suppressed, the purpose of attenuating the common mode currents can be achieved, thereby suppressing the common mode interference noise. The first Y capacitor C1 and the second Y capacitor C2 can play a filtering role on the common mode interference noise, so that the common mode interference can be significantly suppressed. The first Y-capacitor C1 and the second Y-capacitor C2 may be Y-capacitors whose specification parameters correspond to the frequency of electromagnetic compatibility interference, so that the electromagnetic compatibility interference signal can pass through the Y-capacitors more easily. The first Y-capacitor C1 and the second Y-capacitor C2 may be provided so that the electromagnetic compatibility interference signal flowing through can return to the motor M1 and can also be gradually consumed in the form of heat generation, thereby preventing the electromagnetic compatibility interference of the motor M1 from exceeding the standard.

As shown in FIG. 7, in one embodiment, the electromagnetic compatibility filter circuit 20 may further include a second magnetic bead FB2. A first end of the second magnetic bead FB2 may be connected to the motor ground terminal CN22. A second end of the second magnetic bead FB2 may be connected to the first end of the first magnetic bead FB1.

In this embodiment, the second magnetic bead FB2 may be connected between the first magnetic bead FB1 and the motor ground terminal CN22. In other words, one end of the second magnetic bead FB2 may be connected to the motor ground terminal CN22. The other end of the second magnetic bead FB2 may be connected to a ground terminal of the first magnetic bead FB1, the first Y capacitor C1 and the second Y capacitor C2. The second magnetic bead FB2 can be configured to increase impedance between the housing of the motor M1 and the system protection ground GND. Impedance values of the first magnetic bead FB1 and the second magnetic bead FB2 can be the same or different. The common mode current generated by the motor M1 can be firstly suppressed by the second magnetic bead FB2 and consumed in the form of heat generation, and then shunted by the first magnetic bead FB1 and the power filter circuit 10. Most of the common mode current can return to the interference source via the power filter circuit 10, and the electromagnetic compatibility interference signal can be attenuated by the power filter circuit 10, thereby suppressing the transmission of the electromagnetic compatibility interference signal, etc. to the system protection ground GND.

Referring to FIG. 7, in one embodiment, the electromagnetic compatibility filter circuit 20 may further include a third magnetic bead FB3. A first end of the third magnetic bead FB3 may be interconnected with the first magnetic bead FB1 and the second end of the first Y-capacitor C1. A second end of the third magnetic bead FB3 may be interconnected with a second end of the second magnetic bead FB2 and the motor ground terminal CN22.

In this embodiment, the first magnetic bead FB1, the second magnetic bead FB2 and the third magnetic bead FB3 can be provided simultaneously, or only two of the first magnetic bead FB1, the second magnetic bead FB2 and the third magnetic bead FB3 can be provided. In other embodiments, of course, only one of the first magnetic bead FB1, the second magnetic bead FB2 and the third magnetic bead FB3 can be provided, without limitation here. In this embodiment, the first magnetic bead FB1, the second magnetic bead FB2 and the third magnetic bead FB3 are provided simultaneously. The first magnetic bead FB1 may be connected in parallel with the first Y-capacitor C1. The third magnetic bead FB3 may be connected in parallel with the second Y-capacitor C2 and then connected in series with the second magnetic bead FB2. The magnetic beads located in three positions can form different current loops for the common mode interference signal with the first Y capacitor C1 and the second Y capacitor C2 respectively, thus increasing speed of the common mode interference signal back to the interference source. Furthermore, the magnetic beads in each of the three positions can consume the electromagnetic interference signal in the form of heat generation, thereby improving the efficiency of the suppression of the electromagnetic interference signal.

Referring to FIGS. 7 to 9, in one embodiment, the electromagnetic compatibility filter circuit 20 may further include a fourth magnetic bead FB4.

The fourth magnetic bead FB4 may be connected in series between an output end of the common mode choke L1 and the first Y-capacitor C1.

Alternatively, the fourth magnetic bead FB4 may be connected in series between the output end of the common mode choke L1 and the second Y-capacitor C2.

In this embodiment, the quantity of the fourth magnetic bead FB4 may be one. When the quantity of the fourth magnetic bead FB4 is one, the fourth magnetic bead FB4 may be arranged at either end of the first Y capacitor C1 or at either end of the second Y capacitor C2. Providing the fourth magnetic bead FB4 at the above position can improve the electromagnetic suppression effect of the power filter circuit 10. In other embodiments, of course, the quantity of the fourth magnetic bead FB4 may also be multiple. A plurality of fourth magnetic beads FB4 can be arranged at both ends of the first Y-capacitor C1 and both ends of the second Y-capacitor C2, thus improving the effect of electromagnetic suppression of the power supply filter circuit 10. Moreover, the plurality of fourth magnetic beads FB4 can consume the electromagnetic interference signal in the form of heat generation, thereby improving the efficiency of suppression of the electromagnetic interference signal.

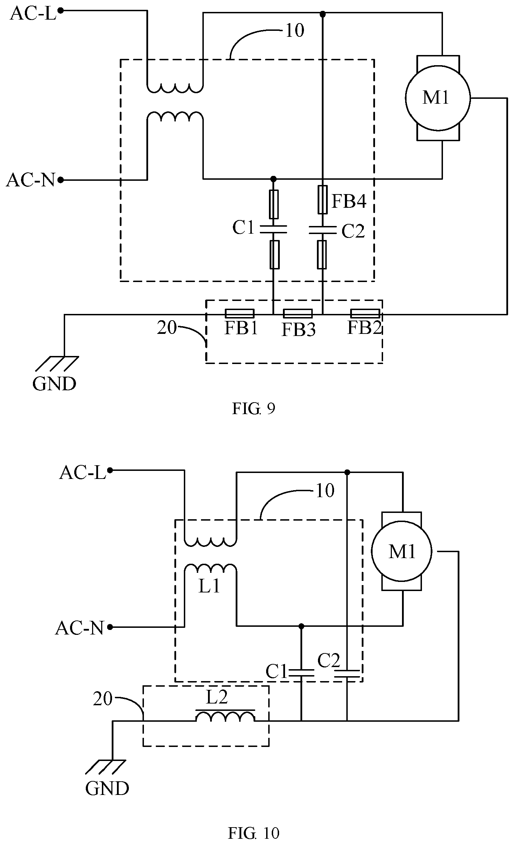

Referring to FIG. 10, in one embodiment, the electromagnetic compatibility filter circuit 20 may include an inductor L2. A first end of the inductor L2 may be the input end of the electromagnetic compatibility filter circuit 20. The second end of the inductor L2 may be the output end of the electromagnetic compatibility filter circuit 20.

In this embodiment, the electromagnetic compatibility filter circuit 20 can be implemented by means of the inductor L2, or a combination of magnetic beads and the inductor L2. The inductor L2 may be configured to increase the high frequency impedance between the housing of the motor M1 and the system protection ground GND, so that the common mode current can return to the interference source of the motor M1 via the power filter circuit 10.

The present disclosure also provides an electrical device. The electrical device may include a motor M1 and an electrical control assembly as described above. A power output terminal of the electric control assembly may be connected to the motor. Detailed configuration of the electrical control assembly can be referred to the above-mentioned embodiments and will not be repeated here. It can be understood that, since the above-mentioned electrical control assembly is adopted in the electrical device of the present disclosure, the electrical device may include all the technical solutions in all the above-mentioned embodiments of the electrical control assembly and can achieve exactly the same technical effect, which will not be repeated here.

In this embodiment, the electrical device can be an air conditioner, washing machine, refrigerator or other electrical device equipped with a motor. Alternatively, the electrical device may be an air conditioner including an indoor unit and an outdoor unit. The electric control assembly may be installed in the outdoor unit of the air conditioner. A mounting section for mounting the electrical control assembly may be arranged in the housing of the outdoor unit. The electrical control assembly may be arranged in the mounting section of the outdoor unit by one or a combination of screwing, bolting, riveting, welding, clamping and plugging.

The above are only preferred embodiments of the present disclosure and are not intended to limit the scope of the present disclosure. The scope of protection is defined in the appended claims.

## Claims

1. An electrical control assembly, comprising
an electrical control board (100), provided with a system protection ground (GND), a power input terminal (CN11) and a ground terminal (CN12) configured to access a power supply, and a power output terminal (CN21) and a motor ground terminal (CN22) configured to access a motor (M1), wherein the ground terminal (CN12) is connected with the system protection ground (GND);
a power filter circuit (10), wherein an input end of the power filter circuit (10) is connected with the power input terminal (CN11), and an output end of the power filter circuit (10) is connected with the power output terminal (CN21);
an electromagnetic compatibility filter circuit (20), wherein an input end of the electromagnetic compatibility filter circuit (20) is connected with the motor ground terminal (CN22) and a ground end of the power filter circuit (10), and an output end of the electromagnetic compatibility filter circuit (20) is connected with the system protection ground (GND); **characterised in that**:
the ground terminal (CN12) comprises a plurality of plug-in ends, the motor ground terminal (CN22) comprises a plurality of plug-in ends, a plurality of printed circuit board wires are arranged on the electrical control board (100), first ends of the plurality of printed circuit board wires are connected to the plurality of plug-in ends of the ground terminal (CN12) in one-to-one correspondence, the other ends of the plurality of printed circuit board wires are connected to the plurality of plug-in ends of the motor ground terminal (CN22) in one-to-one correspondence;
the electromagnetic compatibility filtering circuit (20) comprises a plurality of electromagnetic compatibility filter branches, each of the plurality of electromagnetic compatibility filter branches is connected in series to a corresponding printed circuit board wire.

2. The electrical control assembly as claimed in claim 1, wherein the ground terminal (CN12) comprises two plug-in ends, the motor ground terminal (CN22) comprises two plug-in ends, a first printed circuit board wire and a second printed circuit board wire are arranged on the electrical control board (100), the first printed circuit board wire is connected with a first plug-in end of the motor ground terminal (CN22) and a first plug-in end of the ground terminal (CN12), the second printed circuit board wire is connected with a second plug-in end of the motor ground terminal (CN22) and a second plug-in end of the ground terminal (CN12);
the electromagnetic compatibility filter circuit (20) comprises two electromagnetic compatibility filter branches, one of the two electromagnetic compatibility filter branches is connected in series to the first printed circuit board wire, the other of the two electromagnetic compatibility filter branches is connected in series to the second printed circuit board wire.

3. The electrical control assembly as claimed in claim 2, wherein the electromagnetic compatibility filter circuit (20) comprises a first magnetic bead (FB1), a first end of the first magnetic bead (FB1) is the input end of the electromagnetic compatibility filter circuit (20), a second end of the first magnetic bead (FB1) is the output end of the electromagnetic compatibility filter circuit (20).

4. The electrical control assembly as claimed in claim 3, wherein the quantity of the first magnetic bead (FB1) is multiple, a plurality of the first magnetic beads (FB1) are connected in series to the first printed circuit board wire and the second printed circuit board wire.

5. The electrical control assembly as claimed in claim 2, wherein the electromagnetic compatibility filter circuit (20) comprises an inductor (L2), a first end of the inductor (L2) is the input end of the electromagnetic compatibility filter circuit (20), a second end of the inductor (L2) is the output end of the electromagnetic compatibility filter circuit (20).

6. The electrical control assembly as claimed in claim 3 or 4, wherein the power filter circuit (10) comprises a common mode choke (L1), a first Y-capacitor (C1) and a second Y-capacitor (C2), each of two input ends of the common mode choke (L1) is connected to an input end of the power supply, two output ends of the common mode choke (L1) are connected to a first end of the first Y-capacitor (C1) and a first end of the second Y-capacitor (C2) respectively, a second end of the first Y-capacitor (C1) and a second end of the second Y-capacitor (C2) are each connected to the input end of the electromagnetic compatibility filter circuit (20).

7. The electrical control assembly as claimed in claim 6, wherein the electromagnetic compatibility filter circuit (20) further comprises a second magnetic bead (FB2), a first end of the second magnetic bead (FB2) is connected to the motor ground terminal (CN22), a second end of the second magnetic bead (FB2) is connected to the first end of the first magnetic bead (FB1).

8. The electrical control assembly as claimed in claim 7, wherein the electromagnetic compatibility filter circuit (20) further comprises a third magnetic bead (FB3), a first end of the third magnetic bead (FB3) is interconnected with the first magnetic bead (FB1) and the second end of the first Y-capacitor (C1), a second end of the third magnetic bead (FB3) is interconnected with a second end of the second magnetic bead (FB2) and the second end of the second Y-capacitor (C2).

9. The electrical control assembly as claimed in any one of claims 6 to 8, wherein the electromagnetic compatibility filter circuit (20) further comprises a fourth magnetic bead (FB4), the fourth magnetic bead (FB4) is connected in series between an output end of the common mode choke (L1) and the first Y-capacitor (C1).

10. The electrical control assembly as claimed in any one of claims 6 to 8, wherein the electromagnetic compatibility filter circuit (20) further comprises a fourth magnetic bead (FB4), the fourth magnetic bead (FB4) is connected in series between an output end of the common mode choke (L1) and the second Y-capacitor (C2).

11. The electrical control assembly as claimed in any preceding claim, further comprising a rectifier circuit (30), a power factor correction circuit (40) and an intelligent power module (50) connected in sequence with the power filter circuit.

12. An electrical device, **characterized by** comprising a motor (M1) and the electrical control assembly as claimed in any preceding claim, the power output terminal (CN21) of the electrical control assembly is connected with the motor (M1).

## Patentansprüche

1. Elektrische Steuerungsbaugruppe, umfassend
eine elektrische Steuerungsplatine (100), ausgestattet mit einem Systemschutz-Erdungsleiter (GND), einer Stromeingangsanschlussklemme (CN11) und einer Erdungsanschlussklemme (CN12), die für einen Zugang zu einer Stromversorgung konfiguriert sind, und einer Stromausgangsanschlussklemme (CN21) und einer Motorerdungsanschlussklemme (CN22), die für einen Zugang zu einem Motor (M1) konfiguriert sind, wobei die Erdungsanschlussklemme (CN12) mit dem Systemschutz-Erdungsleiter (GND) verbunden ist;
eine Stromfilterschaltung (10), wobei ein Eingangsende der Stromfilterschaltung (10) mit der Stromeingangsanschlussklemme (CN11) verbunden ist, und ein Ausgangsende der Stromfilterschaltung (10) mit der Stromausgangsanschlussklemme (CN21) verbunden ist;
eine Filterschaltung (20) für elektromagnetische Kompatibilität, wobei ein Eingangsende der Filterschaltung (20) für elektromagnetische Kompatibilität mit der Motorerdungsanschlussklemme (CN22) und einem Erdungsende der Stromfilterschaltung (10) verbunden ist, und ein Ausgangsende der Filterschaltung (20) für elektromagnetische Kompatibilität mit dem Systemschutz-Erdungsleiter (GND) verbunden ist; **dadurch gekennzeichnet, dass**:
die Erdungsanschlussklemme (CN12) eine Mehrzahl von Einsteckenden umfasst, die Motorerdungsanschlussklemme (CN22) eine Mehrzahl von Einsteckenden umfasst, eine Mehrzahl von Kabeln von gedruckten Leiterplatten auf der elektrischen Steuerungsplatine (100) angeordnet sind, erste Enden der Mehrzahl von Kabeln von gedruckten Leiterplatten mit der Mehrzahl von Einsteckenden der Erdungsanschlussklemme (CN12) in eins-zu-eins-Entsprechung verbunden sind, die anderen Enden der Mehrzahl von Kabeln von gedruckten Leiterplatten mit der Mehrzahl von Einsteckenden der Motorerdungsanschlussklemme (CN22) in eins-zu-eins-Entsprechung verbunden sind;
die Filterschaltung (20) für elektromagnetische Kompatibilität eine Mehrzahl von Filterzweigen für elektromagnetische Kompatibilität umfasst, wobei jeder der Mehrzahl von Filterzweigen für elektromagnetische Kompatibilität in Reihe mit einem entsprechenden Kabel von einer gedruckten Leiterplatte verbunden ist.

2. Elektrische Steuerungsbaugruppe nach Anspruch 1, wobei die Erdungsanschlussklemme (CN12) zwei Einsteckenden umfasst, wobei die Motorerdungsanschlussklemme (CN22) zwei Einsteckenden umfasst, wobei ein erstes Kabel von einer gedruckten Leiterplatte und ein zweites Kabel von einer gedruckten Leiterplatte auf der elektrischen Steuerungsplatine (100) angeordnet sind, wobei das erste Kabel von einer gedruckten Leiterplatte mit einem ersten Einsteckende der Motorerdungsanschlussklemme (CN22) und einem ersten Einsteckende der Erdungsanschlussklemme (CN12) verbunden ist, wobei das zweite Kabel von einer gedruckten Leiterplatte mit einem zweiten Einsteckende der Motorerdungsanschlussklemme (CN22) und einem zweiten Einsteckende der Erdungsanschlussklemme (CN12) verbunden ist;
wobei die Filterschaltung (20) für elektromagnetische Kompatibilität zwei Filterzweige für elektromagnetische Kompatibilität umfasst, wobei einer der zwei Filterzweige für elektromagnetische Kompatibilität in Reihe mit dem ersten Kabel von einer gedruckten Leiterplatte verbunden ist, wobei der andere der zwei Filterzweige für elektromagnetische Kompatibilität in Reihe mit dem zweiten Kabel von einer gedruckten Leiterplatte verbunden ist.

3. Elektrische Steuerungsbaugruppe nach Anspruch 2, wobei die Filterschaltung (20) für elektromagnetische Kompatibilität eine erste magnetische Perle (FB1) umfasst, wobei ein erstes Ende der ersten magnetischen Perle (FB1) das Eingangsende der Filterschaltung (20) für elektromagnetische Kompatibilität ist, wobei ein zweites Ende der ersten magnetischen Perle (FB1) das Ausgangsende der Filterschaltung (20) für elektromagnetische Kompatibilität ist.

4. Elektrische Steuerungsbaugruppe nach Anspruch 3, wobei die Quantität der ersten magnetischen Perle (FB1) mehrfach ist, eine Mehrzahl der ersten magnetischen Perlen (FB1) in Reihe mit dem ersten Kabel von einer gedruckten Leiterplatte und dem zweiten Kabel von einer gedruckten Leiterplatte verbunden sind.

5. Elektrische Steuerungsbaugruppe nach Anspruch 2, wobei die Filterschaltung (20) für elektromagnetische Kompatibilität eine Induktivität (L2) umfasst, wobei ein erstes Ende der Induktivität (L2) das Eingangsende der Filterschaltung (20) für elektromagnetische Kompatibilität ist, wobei ein zweites Ende der Induktivität (L2) das Ausgangsende der Filterschaltung (20) für elektromagnetische Kompatibilität ist.

6. Elektrische Steuerungsbaugruppe nach Anspruch 3 oder 4, wobei die Stromfilterschaltung (10) eine Gleichtaktdrossel (L1), einen ersten Y-Kondensator (C1) und einen zweiten Y-Kondensator (C2) umfasst, wobei jedes der zwei Eingangsenden der Gleichtaktdrossel (L1) mit einem Eingangsende der Stromversorgung verbunden ist, wobei zwei Ausgangsenden der Gleichtaktdrossel (L1) jeweils mit einem ersten Ende des ersten Y-Kondensators (C1) und einem ersten Ende des zweiten Y-Kondensators (C2) verbunden sind, wobei ein zweites Ende des ersten Y-Kondensators (C1) und ein zweites Ende des zweiten Y-Kondensators (C2) beide mit dem Eingangsende der Filterschaltung (20) für elektromagnetische Kompatibilität verbunden sind.

7. Elektrische Steuerungsbaugruppe nach Anspruch 6, wobei die Filterschaltung (20) für elektromagnetische Kompatibilität ferner eine zweite magnetische Perle (FB2) umfasst, wobei ein erstes Ende der zweiten magnetischen Perle (FB2) mit der Motorerdungsanschlussklemme (CN22) verbunden ist, wobei ein zweites Ende der zweiten magnetischen Perle (FB2) mit dem ersten Ende der ersten magnetischen Perle (FB1) verbunden ist.

8. Elektrische Steuerungsbaugruppe nach Anspruch 7, wobei die Filterschaltung (20) für elektromagnetische Kompatibilität ferner eine dritte magnetische Perle (FB3) umfasst, wobei ein erstes Ende der dritten magnetischen Perle (FB3) zwischen der ersten magnetischen Perle (FB1) und dem zweiten Ende des ersten Y-Kondensators (C1) verbunden ist, wobei ein zweites Ende der dritten magnetischen Perle (FB3) zwischen einem zweiten Ende der zweiten magnetischen Perle (FB2) und dem zweiten Ende des zweiten Y-Kondensators (C2) verbunden ist.

9. Elektrische Steuerungsbaugruppe nach einem der Ansprüche 6 bis 8, wobei die Filterschaltung (20) für elektromagnetische Kompatibilität ferner eine vierte magnetische Perle (FB4) umfasst, wobei die vierte magnetische Perle (FB4) in Reihe zwischen einem Ausgangsende der Gleichtaktdrossel (L1) und dem ersten Y-Kondensator (C1) verbunden ist.

10. Elektrische Steuerungsbaugruppe nach einem der Ansprüche 6 bis 8, wobei die Filterschaltung (20) für elektromagnetische Kompatibilität ferner eine vierte magnetische Perle (FB4) umfasst, wobei die vierte magnetische Perle (FB4) in Reihe zwischen einem Ausgangsende der Gleichtaktdrossel (L1) und dem zweiten Y-Kondensator (C2) verbunden ist.

11. Elektrische Steuerungsbaugruppe nach einem der vorangehenden Ansprüche, ferner umfassend eine Gleichrichterschaltung (30), eine Leistungsfaktorkorrekturschaltung (40) und ein intelligentes Leistungsmodul (50), die in Reihenfolge mit der Stromfilterschaltung verbunden sind.

12. Elektrische Vorrichtung, **gekennzeichnet durch** Umfassen eines Motors (M1) und der elektrischen Steuerungsbaugruppe nach einem der vorangehenden Ansprüche, wobei die Stromausgangsanschlussklemme (CN21) der elektrischen Steuerungsbaugruppe mit dem Motor (M1) verbunden ist.

## Revendications

1. Ensemble de commande électrique, comprenant :
une carte de commande électrique (100), munie d'une masse de protection système (GND), d'une borne d'entrée de puissance (CN11) et d'une borne de masse (CN12) configurées pour accéder à une alimentation électrique, ainsi que d'une borne de sortie de puissance (CN21) et d'une borne de masse moteur (CN22) configurées pour accéder à un moteur (M1), dans lequel la borne de masse (CN12) est connectée à la masse de protection système (GND),
un circuit de filtre de puissance (10), dans lequel une extrémité d'entrée du circuit de filtre de puissance (10) est connectée à la borne d'entrée de puissance (CN11), et une extrémité de sortie du circuit de filtre de puissance (10) est connectée à la borne de sortie de puissance (CN21) ;
un circuit de filtre de compatibilité électromagnétique (20), dans lequel une extrémité d'entrée du circuit de filtre de compatibilité électromagnétique (20) est connectée à la borne de masse moteur (CN22) et à une extrémité de masse du circuit de filtre de puissance (10), et une extrémité de sortie du circuit de filtre de compatibilité électromagnétique (20) est connectée à la masse de protection système (GND) ; **caractérisé en ce que** :
la borne de masse (CN12) comporte une pluralité d'extrémités enfichables, la borne de masse moteur (CN22) comprend une pluralité d'extrémités enfichables, une pluralité de fils de carte de circuit imprimé sont disposés sur la carte de commande électrique (100), des premières extrémités de la pluralité de fils de carte de circuit imprimé sont connectées à la pluralité d'extrémités enfichables de la borne de masse (CN12) dans une correspondance biunivoque, les autres extrémités de la pluralité de fils de carte de circuit imprimé sont connectées à la pluralité d'extrémités enfichables de la borne de masse moteur (CN22) dans une correspondance biunivoque ;
le circuit de filtrage de compatibilité électromagnétique (20) comprend une pluralité de branches de filtre de compatibilité électromagnétique, chacune des branches de filtre de compatibilité électromagnétique étant connectée en série à un fil de carte de circuit imprimé correspondant.

2. Ensemble de commande électrique selon la revendication 1, dans lequel la borne de masse (CN12) comprend deux extrémités enfichables, la borne de masse moteur (CN22) comprend deux extrémités enfichables, un premier fil de carte de circuit imprimé et un deuxième fil de carte de circuit imprimé sont disposés sur la carte de commande électrique (100), le premier fil de carte de circuit imprimé est connecté à une première extrémité enfichable de la borne de masse moteur (CN22) et à une première extrémité enfichable de la borne de masse (CN12), le deuxième fil de carte de circuit imprimé est connecté à une seconde extrémité enfichable de la borne de masse moteur (CN22) et à une seconde extrémité enfichable de la borne de masse (CN12) ;
le circuit de filtre de compatibilité électromagnétique (20) comprend deux branches de filtre de compatibilité électromagnétique, l'une des deux branches de filtre de compatibilité électromagnétique est connectée en série au premier fil de carte de circuit imprimé, l'autre des deux branches de filtre de compatibilité électromagnétique est connectée en série au deuxième fil de carte de circuit imprimé.

3. Ensemble de commande électrique selon la revendication 2, dans lequel le circuit de filtre de compatibilité électromagnétique (20) comprend un première bille magnétique (FB1), une première extrémité de la première bille magnétique (FB1) est l'extrémité d'entrée du circuit de filtre de compatibilité électromagnétique (20), une seconde extrémité de la première bille magnétique (FB1) est l'extrémité de sortie du circuit de filtre de compatibilité électromagnétique (20).

4. Ensemble de commande électrique selon la revendication 3, dans lequel la quantité de la première bille magnétique (FB1) est multiple, une pluralité de premières billes magnétiques (FB1) est connectée en série au premier fil de carte de circuit imprimé et au deuxième fil de carte de circuit imprimé.

5. Ensemble de commande électrique selon la revendication 2 dans lequel le circuit de filtre de compatibilité électromagnétique (20) comprend une bobine d'induction (L2), une première extrémité de la bobine d'induction (L2) est l'extrémité d'entrée du circuit de filtre de compatibilité électromagnétique (20), une seconde extrémité de la bobine d'induction (L2) est l'extrémité de sortie du circuit de filtre de compatibilité électromagnétique (20).

6. Ensemble de commande électrique selon la revendication 3 ou 4, dans lequel le circuit de filtre de puissance (10) comprend une bobine d'arrêt en mode commun (L1), un premier condensateur en Y (C1) et un second condensateur en Y (C2), chacune des deux extrémités d'entrée de la bobine d'arrêt en mode commun (L1) est connectée à une extrémité d'entrée de l'alimentation électrique, deux extrémités de sortie de la bobine d'arrêt en mode commun (L1) sont connectées à une première extrémité du premier condensateur en Y (C1) et à une première extrémité du second condensateur en Y (C2) respectivement, une seconde extrémité du premier condensateur en Y (C1) et une seconde extrémité du second condensateur en Y (C2) sont chacune connectées à l'extrémité d'entrée du circuit de filtre de compatibilité électromagnétique (20).

7. Ensemble de commande électrique selon la revendication 6, dans lequel le circuit de filtre de compatibilité électromagnétique (20) comprend en outre une deuxième bille magnétique (FB2), une première extrémité de la deuxième bille magnétique (FB2) est connectée à la borne de masse moteur (CN22), une seconde extrémité de la deuxième bille magnétique (FB2) est connectée à la première extrémité de la première bille magnétique (FB1).

8. Ensemble de commande électrique selon la revendication 7, dans lequel le circuit de filtre de compatibilité électromagnétique (20) comprend en outre une troisième bille magnétique (FB3), une première extrémité de la troisième bille magnétique (FB3) est interconnectée avec la première bille magnétique (FB1) et la seconde extrémité du premier condensateur en Y (C1), une seconde extrémité de la troisième bille magnétique (FB3) est interconnectée avec une seconde extrémité de la deuxième bille magnétique (FB2) et la seconde extrémité du second condensateur en Y (C2).

9. Ensemble de commande électrique selon l'une quelconque des revendications 6 à 8, dans lequel le circuit de filtre de compatibilité électromagnétique (20) comprend en outre une quatrième bille magnétique (FB4), la quatrième bille magnétique (FB4) est connectée en série entre une extrémité de sortie de la bobine d'arrêt en mode commun (L1) et le premier condensateur en Y (C1).

10. Ensemble de commande électrique selon l'une quelconque des revendications 6 à 8, dans lequel le circuit de filtre de compatibilité électromagnétique (20) comprend en outre une quatrième bille magnétique (FB4), la quatrième bille magnétique (FB4) est connectée en série entre une extrémité de sortie de la bobine d'arrêt en mode commun (L1) et le second condensateur en Y (C2).

11. Ensemble de commande électrique selon l'une quelconque des revendications précédentes, comprenant en outre un circuit redresseur (30), un circuit de correction de facteur de puissance (40) et un module de puissance intelligent (50) connectés en séquence au circuit de filtre de puissance.

12. Dispositif électrique, **caractérisé en ce qu'**il comprend un moteur (M1) et l'ensemble de commande électrique selon l'une quelconque des revendications précédentes, la borne de sortie de puissance (CN21) de l'ensemble de commande électrique est connectée au moteur (M1).
